# EUROPEAN PATENT APPLICATION

(11) **EP 4 852 637 A1**
(43) Date of publication of application: **09.12.2026**
(21) Application number: 26180259.9
(22) Date of filing: 21.05.2026
(51) Int. Cl.: H05K 7/20

(54) **METHOD FOR CONTROLLING A SYSTEM COMPRISING A PLURALITY OF COOLING SYSTEMS, AND A SYSTEM COMPRISING A PLURALITY OF COOLING SYSTEMS**

(30) Priority: 06.06.2025 GB 202508958
(71) Applicant: Vodafone Group Services Limited, Newbury RG14 2FN (GB)
(72) Inventor: LAW, Alan, London, W2 6BY (GB); TURK, John, London, W2 6BY (GB)
(74) Representative: Boult Wade Tennant LLP

(57) **Abstract**

A method for controlling a system comprising electronic equipment, the electronic equipment comprising a first cooling system, and an enclosure in which the electronic equipment is installed, the enclosure comprising a second cooling system. The method comprises cooperatively operating the first and second cooling systems based on electrical power information associated with the first cooling system for a temperature of part of the system, and electrical power information associated with the second cooling system for the temperature.

## Description

### FIELD

The disclosure relates generally to methods for controlling systems comprising a plurality of cooling systems and systems comprising a plurality of cooling systems.

### BACKGROUND

Electronic equipment may be installed within an enclosure or cabinet. For example, a typical roadside cabinet for radio base station equipment may have a server installed inside.

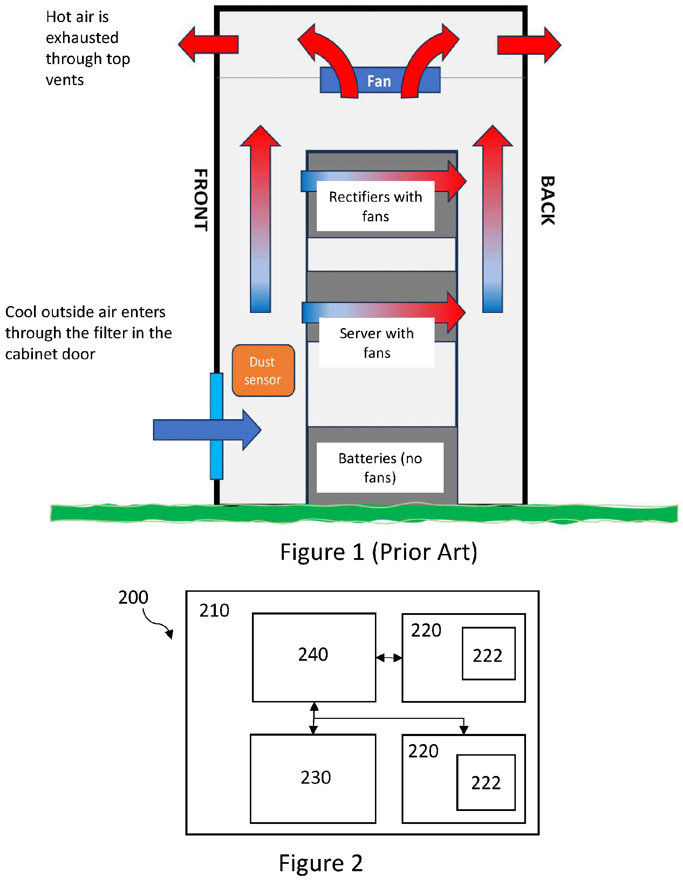

These cabinets may be useful to protect the electronic equipment from the surrounding environment or to prevent unauthorised access to the equipment. However, the enclosures also trap heat, causing temperatures to rise within the enclosure. This can lead to overheating of the electrical items, which can result in additional maintenance work and early component failure. Enclosures therefore typically also include a cooling system. A roadside cabinet can thus maintain a suitable internal air temperature by using a fan to draw in cool external air and expel hot internal air, as illustrated in Figure 1.

The items installed inside a roadside cabinet typically also have cooling fans to maintain a particular temperature of the electrical item. This is because the electrical items include components (for example, processors) that need to be kept cool to operate optimally and extend their lifetimes. These fans draw in air from the cabinet to cool the item and expel hot air back into the cabinet.

However, given the various requirements of each piece of equipment and the number of different cooling systems, it can be difficult to efficiently operate the various cooling systems. As a result, in some cases, power consumption of the cooling systems can be unnecessarily high.

Methods and systems that overcome these issues is desirable.

### SUMMARY

One or more electrical items are installed within an enclosure or enclosed frame. At least one of the electrical items includes a cooling system, which may be a fan-based cooling system. The cooling system is employed to maintain (or attempt to maintain) a particular temperature of the electrical item. This is typically to keep a processor (for example, a central processing unit, CPU) or other integrated circuit chip temperature sufficiently low. This is because the lifetime of the chip is affected by high temperatures, and the conductivity of the materials (for example, silicon) that make up the chip can also be reduced at high temperatures. A coolant inlet temperature may be used as an indicator of the chip temperature (or a temperature of another part of the system). For example, if incoming air is 70°C, then this may indicate that the temperature of the chip is at least 70°C.

Enclosures are generally used to protect the electrical items (for example, from malicious actors or environmental damage). However, the enclosures also trap heat, causing temperatures to rise within the enclosure. This can lead to overheating of the electrical items, which can result in additional maintenance work and early component failure. The enclosure therefore also includes a separate cooling system for the enclosure itself. In typical systems, this means that the enclosure cooling system operates entirely separately from the electrical item cooling system. However, this can lead to inefficiencies - for example, in power consumption of the cooling systems.

In accordance with the present disclosure, the separate enclosure cooling system is controlled or operated whilst taking into account operation of the electrical item cooling system as well, based on electrical power information for each of the two cooling systems. That is, rather than both cooling systems being controlled by separate controllers and operating according to individual requirements of the respective cooling system, both cooling systems are controlled together and according to joint requirements.

In typical systems, both of the cooling systems may comprise one or more fans and the enclosure fan may operate at high power to keep the temperature inside the enclosure as low as possible. This may result in the electrical item fan operating at low power, since the air surrounding it (used as a coolant for the electrical item fan) is cool.

However, this may counter-intuitively result in a higher power consumption than if the enclosure fan were to operate at a slightly slower speed, allowing the temperature within the enclosure to rise and the electrical item fans to operate slightly faster. By controlling both cooling systems together based on electrical power information for both systems, such irregularities and non-linear relationships between the cooling effect of the cooling systems versus, for example, the power consumption of the cooling systems can be addressed. The power consumption of such systems can thus be reduced, limited or minimised.

In accordance with a first aspect, there is provided a method for controlling a system comprising electronic equipment, the electronic equipment comprising a first cooling system, and an enclosure in which the electronic equipment is installed, the enclosure comprising a second cooling system, the method comprising:
co-operatively operating the first and second cooling systems based on electrical power information associated with the first cooling system for a temperature of part of the system, and electrical power information associated with the second cooling system for the temperature.

Co-operatively operating the first and second cooling systems may mean operating the first and second cooling systems based on the combination of electrical power information of both systems. In other words, rather than operating each system according to the respective electrical power information of the system, both systems are operated according to the electrical power information of both systems. This may involve operating the first and second cooling systems (and more, where present) using a single cooling system management unit.

Existing systems having electrical items including fans and being installed in a cabinet, the cabinet itself also including fans, control the cabinet fans and the fans of the installed items independently. In other words, the cabinet fans are controlled according to programming of a cabinet fan controller and the installed item fans are controlled according to programming of an electrical item fan controller. This can lead to inefficiencies, such as unnecessarily high power consumption from the fans.

By co-operatively operating the first and second cooling systems, the cooling systems can work together to limit the combined power of the cooling systems or otherwise improve the efficiency of the cooling systems overall.

In some examples, co-operatively operating the first and second cooling systems may comprise applying a target temperature for the part of the system based on the power information associated with the first and second cooling systems for the temperature. For example, there may be situations where operating one cooling system at an apparently less efficient manner (for example, allowing the temperature within the enclosure to rise and operating the electronic equipment cooling system at higher power) is more efficient for the system as a whole. A target temperature may thus be set to allow the cooling systems to operate in this manner.

The target temperature may comprise a temperature differential based on the temperature of the part of the system. In other words, the target temperature may be set indirectly via a temperature differential (for example, reducing the temperature of the part of the system by 20°C).

The method may further comprise determining a relationship between the temperature and electrical power data associated with the first cooling system and electrical power data associated with the second cooling systems to co-operatively operate the first and second cooling systems. This may allow the determination of irregularities and non-linearities in the relationship between the two parameters, which can be used to operate the system (in particular, the combination of cooling systems) more efficiently. For example, the relationship may be a non-linear relationship.

In some examples, a relationship between the temperature and electrical power data associated with the first cooling system and a separate relationship between the temperature and electrical power data associated with the second cooling systems may be determined to determine the relationship between all three parameters.

In other examples, co-operatively operating the first and second cooling systems may comprise co-operatively operating the first and second cooling systems based on a predetermined relationship between the temperature and electrical power data of the first and second cooling systems, and the electrical power information associated with the first and second cooling systems for the temperature. This may mean that previously identified irregularities and non-linearities in the relationship between the two parameters can be used to operate the system (in particular, the combination of cooling systems) more efficiently.

The electrical power data of the relationship may comprise the electrical power information associated with the first and second cooling systems for the temperature. In other examples, different electrical power information may be used.

Optionally, the enclosure comprises a cabinet. The cabinet may be an outdoor cabinet. Outdoor cabinets may be weatherproof or weather-resistant cabinets, for example. Outdoor cabinets are typically opaque and constructed from metal panels (in contrast to, for example, data centre cabinets, which may have transparent glass doors).

The cabinet may be a roadside or trackside cabinet, or a cabinet otherwise configured for outdoor use. For example, the cabinet may be positioned outside a warehouse or other structure. Other types of outdoor cabinet may also be used.

Outdoor cabinets are exposed to outdoor atmospheric air, which might vary between -5°C and 30°C, or more, for example. Such temperature variations may mean that there is no longer a direct correlation or otherwise simple relationship between electrical power consumption of the electronic equipment in the cabinet and the temperature of the part of the system. This is in contrast to racks and cabinets in data centres, for example, where the temperature is carefully controlled and the surrounding air may typically be the same temperature (or at least, varying significantly less). In these circumstances, it may be reasonable to assume that there is a linear relationship between electrical power consumption and the temperature of the part of the system.

Furthermore, in data centres, electronic items tend to be installed within frames or racks, in which the electronic items are exposed to an open channel of air, rather than in cabinets. This makes it even more difficult to determine any relationship between the cooling effect of a cooling system and its electrical power consumption. A (closed) enclosure on the other hand has a defined inlet and outlet.

In some examples, the electronic equipment may comprise one or more of: telecommunications equipment, network equipment, transmission equipment, power supply equipment, and power control equipment.

The electronic equipment may be configured to communicate with an antenna, which may specifically be an antenna of a telecommunications network. For example, the electronic equipment may be telecommunications or network equipment and the cabinet may be an outdoor cabinet. The antenna and telecommunications or network equipment may form part of a base station, for example.

The electronic equipment may comprise one or more of: one or more servers, one or more rectifiers, one or more routers or modems, and one or more baseband units. Other types of electronic equipment may be present or may be installed within the enclosure instead.

Optionally, the coolant may be air. Where the enclosure comprises an outdoor cabinet, the temperature variation experienced by the cabinet may therefore be even more relevant, as the coolant for the enclosure cooling system may be the outside air.

In some examples, at least one of the first and second cooling systems may comprise a fan. For example, one or both of the cooling systems may comprise a liquid cooling system including a fan. In another example, one or both of the cooling systems may comprise an air cooling system including a fan. Other cooling systems including fans may also be used.

In some implementations, the electrical power information may comprise one or more of: a current, a voltage, an electrical power, a fan speed of the fan, and an acoustic fan noise level. The electrical power information may, for example, be an electrical fan power of 2W for an inlet temperature of 10°C. In some examples, the electrical power information may be an electrical power to maintain the inlet temperature or the temperature of the part of the system (for instance, the cabinet fan power being 90W to maintain the 10°C inlet temperature).

A fan speed may be linked to an electrical power of the fan (the fan operating at higher power the faster the fan rotates) and likewise an acoustic fan noise level may be linked to an electrical power of the fan (the fan operating at higher power the louder the fans are). Thus, a fan speed or fan noise level may be correlated with the temperature of the part of the system.

Optionally, the method may further comprise periodically reporting, by the electronic equipment, the temperature of the part of the system. This can allow the co-operative fan operation to be adjusted as the temperature changes.

The electrical power information may comprise electrical power consumption information. The cooling effect of the cooling system versus the electrical power required to achieve that cooling effect can be identified. Co-operatively operating the plurality of cooling systems of the enclosure and the electronic equipment may accordingly comprise co-operatively operating the first and second cooling systems based on a combined electrical power consumption of the first cooling system and the second cooling system.

In some implementations, the electrical power information associated with the second cooling system for the temperature may comprise electrical power information associated with the second cooling system for a temperature differential between the temperature and an air temperature outside the enclosure. For example, the enclosure cooling system may require an electrical power of 70W to maintain a temperature differential between the temperature of the part of the system and the outside air temperature of 40°C (for example, between an outside temperature of 0°Cand an internal enclosure temperature of 40°C).

Optionally, co-operatively operating the first and second cooling systems may comprise co-operatively operating the first and second cooling systems to reduce or minimise a combined electrical power consumption of the first and second cooling systems.

In some examples, the temperature of the part of the system may comprise a coolant inlet temperature of the electronic equipment and/or a temperature within the enclosure (for example, a temperature in a particular location of the enclosure).

In accordance with a second aspect, there is provided a system comprising:
electronic equipment comprising a first cooling system;
an enclosure in which the electronic equipment is installed, the enclosure comprising a second cooling system; and
a cooling system management unit in communication with the electronic equipment and the second cooling system, wherein the cooling system management unit is configured to co-operatively operate the first cooling system and the second cooling system based on received electrical power information associated with the first cooling system for a temperature of part of the system, and received electrical power information associated with the second cooling system for the temperature.

By co-operatively operating the first and second cooling systems via a single cooling system management unit, the cooling system management unit can operate to control the cooling systems to work together to limit the combined power of the cooling systems or otherwise improve the efficiency of the cooling systems overall.

Optionally, the enclosure comprises a cabinet. The cabinet may be an outdoor cabinet. For example, the cabinet may be a roadside, trackside or otherwise outside cabinet. For example, the cabinet may be positioned outside a warehouse or other structure. Other types of outdoor cabinet may also be used.

Outdoor cabinets are exposed to outdoor atmospheric air, which might vary between -5°C and 30°C, or more. Such temperature variations may mean that there is no longer a direct correlation or otherwise simple relationship between electrical power consumption of the electronic equipment in the cabinet and the temperature of the part of the system. This is in contrast to cabinets in data centres, for example, where the surrounding air may typically be the same temperature (or at least, varying significantly less) and so it may be reasonable to assume that there is a linear relationship between electrical power consumption and the temperature of the part of the system.

In some examples, the electronic equipment may comprise one or more of: telecommunications equipment, network equipment, transmission equipment, power supply equipment, and power control equipment.

For example, the electronic equipment may comprise one or more of: one or more servers, one or more rectifiers, one or more routers or modems, and one or more baseband units.

Optionally, the coolant may be air. Where the enclosure comprises an outdoor cabinet, the temperature variation experienced by the cabinet may therefore be even more relevant, as the coolant for the enclosure cooling system may be the outside air.

In some examples, at least one of the first and second cooling systems may comprise a fan. For example, one or both of the cooling systems may comprise a liquid cooling system including a fan. In another example, one or both of the cooling systems may comprise an air cooling system including a fan.

In some examples, the cooling system management unit may be configured to co-operatively operate the first cooling system and the second cooling system by sending an indication to the electronic equipment to adjust a first cooling system electrical power and sending a separate indication to the second cooling system to adjust a second cooling system electrical power. The first and second cooling systems may thus be co-operatively operated but separately controlled by the cooling system management unit.

The indication may be a command or a request to adjust the cooling system electrical power, for example.

The system may be configured in accordance with any of the methods described above.

The methods described above may be implemented as a computer program comprising instructions to operate a computer or computer system. The computer program may be stored on a computer-readable medium, which may be non-transitory.

The computer system may include a processor, such as a central processing unit (CPU). The processor may execute logic in the form of a software program. The computer system may include a memory including volatile and non-volatile storage medium. The different parts of the system may be connected using a network (for example, wireless networks and wired networks). The computer system may include one or more interfaces. The computer system may contain a suitable operating system such as UNIX (RTM) (including Linux (RTM)), Windows (RTM), for example.

It should be noted that any feature described herein may be used with any particular aspect or embodiment of the invention. Moreover, the combination of any specific apparatus, structural or method features is also provided, even if that combination is not explicitly disclosed.

The invention will now be described with reference to the attached drawings depicting different embodiments thereof, the drawings being provided purely by way of example and not limitation.

### BRIEF DESCRIPTION OF DRAWINGS

The invention may be put into practice in a number of ways, and preferred embodiments will now be described by way of example only and with reference to the accompanying drawings, in which:
Figure 1 shows a typical roadside cabinet with a fan for cooling the cabinet and having electronic equipment installed therein;
Figure 2 illustrates a schematic system according to an embodiment of the disclosure;
Figure 3 shows an exemplary system comprising a cabinet comprising a cooling system, a plurality of electronic equipment comprising respective cooling systems comprising a fan and a cooling system management system according to an embodiment of the disclosure;
Figure 4 illustrates graphically an exemplary relationship between a device inlet temperature and power consumption of an enclosure cooling system and electronic equipment cooling systems; and
Figure 5 illustrates a flow chart of a method for controlling a system according to an embodiment of the disclosure.

It should be noted that the Figures are illustrated in schematic form for simplicity and are not necessarily drawn to scale. Like features are provided with the same (or similar) reference numerals.

### DESCRIPTION OF PREFERRED EMBODIMENTS

Electronic components typically operate more efficiently and effectively within a particular temperature range. Electronic equipment therefore often uses a coolant (for example, a fluid such as air or water) to cool such electronic components as and when they heat up during operation. Fans are usually included in the electronic equipment to provide the necessary cooling. The electronic equipment is installed within an enclosure that itself uses a coolant (which may also be air) to maintain, or attempt to maintain, a particular temperature within the enclosure. This is again to try to keep the components within the electronic equipment operating within a suitable temperature range.

Figure 2 illustrates a block diagram of a system 200 configured in accordance with the methods discussed herein. The system includes an enclosure 210, an enclosure cooling system 230 and electronic equipment 220 comprising a cooling system 222.

The electronic equipment 220 may comprise telecommunications equipment. For example, the electronic equipment 220 may comprise a computer server for telecommunications and may more specifically be an Open Radio Access Network (RAN) server. The Open RAN server may be a central unit (CU) or distributed unit (DU) server. In yet further examples, the electronic equipment 220 may also or instead comprise networking hardware - that is, hardware to provide communications and/or interaction between devices in a network. The networking hardware may again comprise a computer server.

Other examples of electronic equipment that may be included in the system 200 include transmission equipment, power supply equipment, and power control equipment. Such equipment may typically be installed in an outdoor enclosure. Yet further examples of electronic equipment include data storage equipment, audiovisual equipment, scientific equipment and radio equipment.

The electronic equipment 220 may more specifically include one or more of: an amplifier, data switch, data router, rectifier, server, one or more batteries, and so on.

It will be appreciated that other components and systems may be present in the electronic equipment 220 for its operation that are not illustrated in Figure 2. The electronic equipment 220 may, for instance, comprise one or more of: a CPU, GPU, hardware accelerator, sound card, and so on. In other words, any component or subsystem typically used in electronic equipment or to provide typical or specialised operation of electronic equipment may be present.

The system further comprises a cooling system management unit 240 (CSMU). The CSMU 240 is in communication with the electronic equipment 220 and the enclosure cooling system 230. The CSMU 240 may be in communication with the electronic equipment 220 and the enclosure cooling system 230 via a wired or wireless interface. One example of a wired interface is an RS-485 interface, defined in ANSI/TIA/EIA-485-A-1998, which is a widely used standard interface. Other wired interfaces may be used.

The CSMU 240 is configured to co-operatively (that is, taking into consideration both systems) operate the enclosure cooling system 230 and the cooling system 222 in the electronic equipment 220. The CSMU 240 may be configured to operate the cooling system 222 by sending an indication (for example, an instruction or request) to the electronic equipment 220 to operate the cooling system 222 in a particular manner. In other words, the CSMU 240 may indirectly operate the cooling system 222. In other examples, the CSMU 240 may specifically be in communication with the cooling system 222 and may send the indication directly to the cooling system 222.

The CSMU 240 is configured to co-operatively operate the cooling systems 230, 222 based on received electrical power information associated with the respective cooling systems for a temperature of part of the system 200. The temperature of the part of the system 200 may be a coolant inlet temperature, for example. Coolant inlet temperatures may typically be used in cooling systems to identify how effectively the cooling system is operating, whether the cooling system needs to be engaged or adjusted, and so on. The coolant inlet temperature may specifically be a coolant inlet temperature of the electronic equipment 220.

In other examples, the temperature of the part of the system 200 may be a temperature inside the enclosure 210. The temperature inside the enclosure 210 may be a temperature within a particular location within the enclosure 210. For example, since hot air rises, a temperature towards the top of the enclosure 210 may be used. This temperature may provide an indication of how hot the electronic equipment 220 is (particularly towards the top of the enclosure 210).

In other examples, the temperature inside the enclosure 210 may be a temperature towards the bottom of the enclosure 210. This may be where cool air enters the enclosure as part of the cooling system 230 and so may provide an indication of the outside air temperature. In some cases, the temperature may specifically be a coolant inlet temperature of the enclosure 210.

In yet further examples, the temperature within the enclosure 210 may be an average temperature - for example, an average of a temperature towards the top of the enclosure 210 and a temperature towards the bottom of the enclosure 210.

The temperature of the part of the system 200 may be reported to the CSMU 240. For example, the electronic equipment 220 may communicate its inlet air temperature to the CSMU 240. In cases where there is a plurality of electronic equipment 220, each piece of electronic equipment 220 may communicate its respective air inlet temperature to the CSMU 240.

In further examples, the enclosure cooling system 230 may communicate the temperature of the part of the system 200 (for example, an internal temperature) to the CSMU 240. In other examples, the CSMU 240 may include one or more temperature sensors to obtain the temperature of the part of the system 200. In yet further examples, a combination of these options may be implemented. For example, temperature measurements may be received from the enclosure cooling system 230 and each piece of electronic equipment 220.

In implementations where one or more temperatures are reported to the CSMU 240, the one or more temperatures may be reported a plurality of times over a period of time. For example, the one or more temperatures may be reported periodically - for example, every five seconds, ten seconds, fifteen seconds, and so on (although it will be appreciated that other periods may be used instead).

The electrical power information may comprise electrical power values for operating the cooling system for a particular temperature. In other examples, the electrical power information may comprise an indication of the electrical power for a particular temperature. For instance, the electrical power information may comprise an acoustic fan noise level and/or a fan rotation speed.

The association between the electrical power information and the temperature may be that the electrical power information is an electrical power, voltage or current (or another parameter) required to maintain that temperature. In other examples, the association may be an electrical power, voltage or current (or another parameter) of a cooling system when operating at a particular temperature.

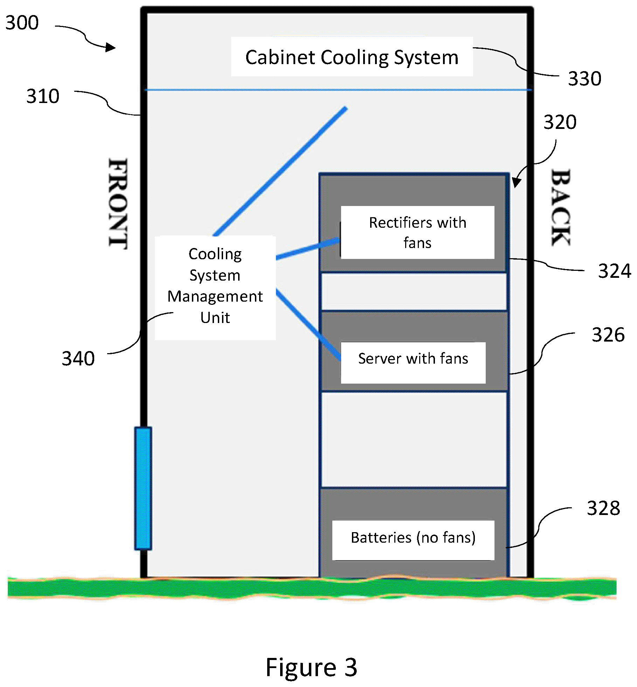

In some examples, the association between the electrical power information for the first cooling system 222 for the temperature of the part of the system and the association between electrical power information for the second cooling system 230 for the temperature of the part of the system may be different. For example, the electrical power information associated with the first cooling system 222 for the temperature of the part of the system may be electrical power information for operation at that temperature or given that temperature, and the electrical power information associated with the second cooling system 230 for the temperature of the part of the system may be electrical power information required to maintain that temperature. An exemplary implementation of this electrical power information will be discussed in more detail with reference to Figure 3.

The cooling system management unit 240 may specifically be a fan management unit. In examples where the electrical power information comprises power consumption information, the cooling system management unit 240 may also be referred to a cooling system energy management unit 240. In cases where each cooling system 222, 230 comprises a fan, the CSMU 240 may be termed a fan energy management unit 240.

The CSMU 240 may include logic configured to determine a configuration of the cooling systems to be able to reduce, minimise or limit a combined electrical power consumption of the enclosure and electronic cooling systems.

It will be appreciated that the only one piece of electronic equipment 220 comprising a cooling system 222 may be present in the enclosure 210, or that further electronic equipment 220 may be present. In some examples, in addition to one piece of electronic equipment 220 comprising a cooling system 222, there may be electronic equipment 220 within the enclosure 210 that does not include a cooling system.

Although Figure 2 illustrates the CSMU 240 as a separate entity within the enclosure 210, the CSMU 240 may form part of the enclosure cooling system 230, which may then interface with the electronic equipment 220 to be able to operate the plurality of cooling systems 230, 222 in co-ordination with each other.

It will be appreciated that the arrangement of elements in Figure 2 is exemplary and the CSMU 240, electronic equipment 222 and enclosure cooling system 230 may be arranged differently within the enclosure 210. For example, an enclosure cooling system 230 may typically be arranged towards the top of the enclosure 210.

Figure 3 illustrates a specific embodiment of the system 200 described with reference to Figure 2. It will be understood that the features discussed with reference to Figure 2 may apply to the embodiment discussed with reference to Figure 3, and vice versa.

In Figure 3, the system 300 comprises an outdoor cabinet or enclosure 310, a cabinet cooling system 330 including a fan, a plurality of pieces of electronic equipment 320 comprising a cooling system, as well as electronic equipment without a cooling system. In this example, the electronic equipment 320 having cooling systems include one or more rectifies 324, each rectifier 324 having a cooling system including a fan, and one or more servers 326, each server 326 having a cooling system including a fan. It will be understood that in other implementations, only some of the electronic equipment cooling systems may include a fan. The electronic equipment without a cooling system comprises one or more batteries 328.

One exemplary embodiment of controlling a system in accordance with the methods discussed herein will now be described with reference to Figure 3, in which electronic equipment inlet temperatures for a particular outside air temperature are used to interdependently operate the cooling systems. However, it will be appreciated that electrical power information for temperatures of different parts of the system 300 and/or different outside air temperatures may be used. Furthermore, different types of electrical power information (rather than electrical power values) may be used.

The CSMU 340 may be programmed with or otherwise receive (for example, from the electronic equipment 320) electrical power information for each piece of electronic equipment 320 having a cooling system. For example, the electrical power information could be manually entered and retrieved by the CSMU 340, or received by automated signalling (for example, electrical, optical or radio signalling).

Exemplary information that may be used is provided in Table 1 below, but it will be appreciated that the CSMU 340 may be programmed or receive the information in another format. In the following example, the cooling systems of the electronic equipment 320 each comprise a fan, but it will be understood that different information for other types of cooling system may be used.

**Table 1: Fan power required for different devices according to internal cabinet temperature**

| Device inlet temperature (°C) | Device fan power at this temperature (W) | Device fan power at this temperature (W) | Device fan power at this temperature (W) | Device fan power at this temperature (W) |
|---|---|---|---|---|
| | Server 1 | Server 2 | Rectifier 1 | Rectifier 2 |
| 10 | 2 | 2 | 2 | 2 |
| 20 | 2 | 2 | 2 | 2 |
| 30 | 2 | 2 | 2 | 2 |
| 40 | 5 | 5 | 5 | 5 |
| 50 | 10 | 10 | 10 | 10 |
| 60 | 20 | 20 | 20 | 20 |
| 70 | 35 | 35 | 35 | 35 |
| 80 | 55 | 55 | 55 | 55 |
| 90 | 70 | 70 | 70 | 70 |

Thus, Table 1 illustrates a fan power consumption of the electronic equipment for a range of device inlet temperatures - in particular, for operation of the fans within the cooling systems of the electronic equipment 320 at specific device inlet temperatures.

The device inlet temperature is related to the internal temperature of the enclosure 310 and electrical power information of the enclosure cooling system 330 for the internal temperature of the enclosure 310. For example, to provide the internal temperature of the enclosure 310, the fan of the enclosure cooling system 330 operates with a particular power consumption. This power consumption may vary according to the temperature of the air outside the enclosure 310 and/or the temperature of a coolant received from outside the enclosure. If the fan of the cooling system 330 is operating at low power, the internal temperature inside the cabinet 310 will rise (thus increasing the device inlet temperature), but if the fan is operating at high power, then the internal temperature of the cabinet 310 will approach the temperature of the external environment. Table 2 below illustrates exemplary electrical power information for a fan of the cabinet cooling system 330 when the outside air temperature is 0°C.

**Table 2: Example cabinet fan power required to deliver certain internal temperatures when outside air temperature is 0°C**

| Device inlet temperature (°C) | Cabinet fan power to maintain this temperature (W) |
|---|---|
| 10 | 100 |
| 20 | 90 |
| 30 | 80 |
| 40 | 70 |
| 50 | 60 |
| 60 | 50 |
| 70 | 40 |
| 80 | 30 |
| 90 | 20 |

The CSMU 340 can use the electrical power information for the cabinet cooling system 330 and cooling systems of the electronic equipment to control the system 330 and, in particular, co-operatively operate the cooling systems. Table 3 below illustrates exemplary electrical power information that may be used to co-operatively operate the cooling systems, based on the electrical power information illustrated in Tables 1 and 2.

**Table 3: Total fan power for a range of internal temperatures when outside air temperature is 0°C**

| Device inlet temperature (°C) | Total fan power to maintain this temperature (W) |
|---|---|
| 10 | 108 |
| 20 | 98 |
| 30 | 88 |
| 40 | 90 |
| 50 | 100 |
| 60 | 130 |
| 70 | 180 |
| 80 | 250 |
| 90 | 300 |

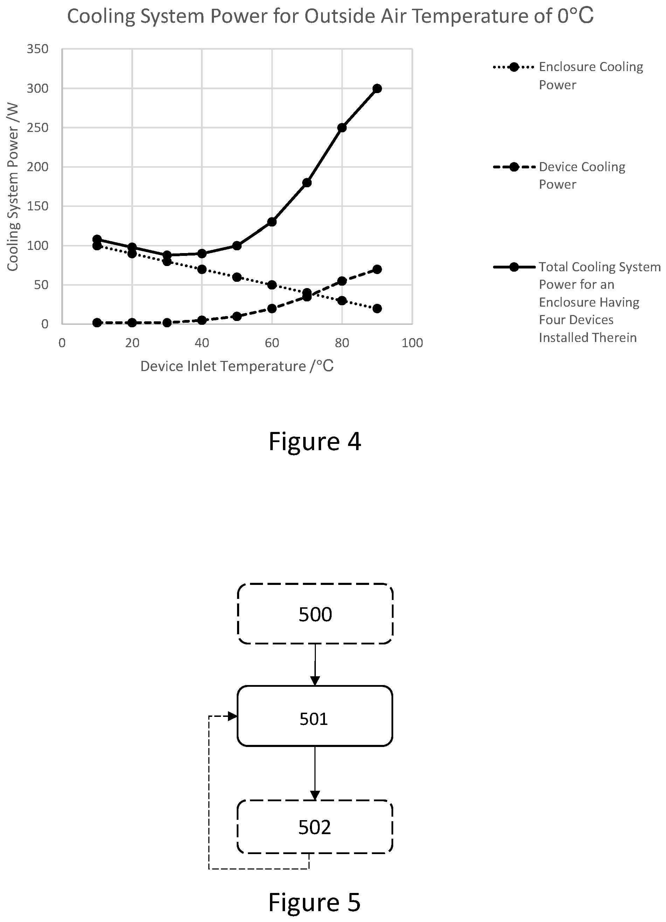

The CSMU 340 may use this information to reduce, minimise or limit a combined electrical power consumption of the enclosure and electronic cooling systems. For example, as can be seen from Table 3 and Figure 4 (which graphically illustrates the information in Tables 1 to 3), for an outside air temperature of 0°C, the minimum total fan power is 88W, when the internal temperature is 30°C. Thus, counter-intuitively, on a cold day, it is most efficient to operate the enclosure cooling system relatively powerfully. In this particular scenario, the internal enclosure temperature can be maintained without increasing the power consumption of the electrical equipment cooling system fans. In other cases, the increase in power consumption of the electrical equipment cooling system fans may still be less than the decrease in the power consumption of the enclosure cooling system.

As can be seen from Tables 1 to 3, the number of devices installed within the enclosure that have cooling systems may impact the temperature of the part of the system at which the combined electrical power consumption is reduced, minimised or limited. For example, where only three pieces of electronic equipment having cooling systems are installed within the enclosure, the temperature at which the total electrical power consumption is lower may be different. With reference to the exemplary data in Table 1, where two servers and one rectifier is present, the total power consumption is minimised for a coolant inlet temperature of 40°C.

Based on the electric power information for the cooling systems, the CSMU 340 can send a signal to at least one of the cooling systems to adjust its electrical power. In other words, the CSMU 340 can send an indication to at least one of the cooling systems to cause it to operate at higher or lower power. In some cases, the CSMU 340 may send a signal to more than one cooling system. It will be appreciated that the CSMU 340 may send the signal via the electronic equipment 320 where the cooling system(s) to be adjusted are comprised within the electronic equipment 320. That is, the CSMU 340 may simply send the signal to the relevant electronic equipment 320 and the electronic equipment 320 may adjust its cooling system.

In some examples, the CSMU 340 may set a target temperature for the part of the system. The CSMU 340 may instruct the cooling system(s) to adjust their electrical power by setting the target temperature.

In some implementations, the CSMU 340 may not co-operatively operate the cooling systems to minimise the power consumption. In some cases, the minimal power consumption may require a temperature suboptimal or otherwise inappropriate for the electronic equipment 320. For example, the temperature may be a temperature at which processors in the electronic equipment operate too slowly. The CSMU 340 may instead co-operatively operate the cooling systems to operate within a particular temperature range. In yet further examples, the CSMU 340 may co-operatively operate the cooling systems to minimise, reduce or limit a combined electrical power consumption of the enclosure and electronic cooling systems within a specified temperature range.

The CSMU 340 may receive additional information to allow the cooling systems and/or electronic equipment to operate more efficiently. For example, the CSMU 340 may receive operating temperature ranges for the electronic equipment installed within the cabinet 310. The operating temperature ranges may include maximum and minimum temperature ranges.

Figure 5 illustrates a flow chart of a method for controlling or operating a system comprising electronic equipment, an enclosure in which the electronic is installed, and a plurality of cooling systems, wherein at least one cooling system is comprised within the enclosure and at least one cooling system is comprised within the electronic equipment. The system may be a system as described with reference to Figures 2 or 3.

In some examples, the method may comprise, at step 500, determining a relationship between the temperature and electrical power data associated with the first cooling system and electrical power data associated with the second cooling systems to co-operatively operate the first and second cooling systems. In other words, a relationship between the three parameters may be determined. An exemplary relationship that may be determined is illustrated in Figure 4 by the solid line.

In some examples, a relationship between the temperature and electrical power data associated with the first cooling system may be determined and a separate relationship between the temperature and electrical power data associated with the second cooling systems may also be determined. These two relationships may then be used to determine the relationship between all three parameters. Figure 4 shows exemplary relationships (the dotted and dashed lines) that may be used to determined the relationship between all three parameters shown by the solid line.

In other examples, the relationship may be predetermined (for example, provided to a cooling system management unit or another part of the system) and used to co-operatively operate the cooling systems. In this case, step 500 need not occur.

At step 501, the method comprises co-operatively operating the first and second cooling systems based on electrical power information associated with the first cooling system for a temperature of part of the system, and electrical power information associated with the second cooling system for the temperature.

The electrical power data used to determine the relationship in step 500 (where performed) may comprise the electrical power information associated with the first and second cooling systems for the temperature. In other examples, different electrical power information may be used. For example, there may be a known relationship between the electrical power data and the electrical power information that allows the determined or predetermined relationship to be used to co-operatively operate the first and second cooling systems based on the electrical power information. For example, the electrical power data and electrical power information may have a proportional relationship.

Co-operatively operating the first and second cooling systems need not require operating both cooling systems. Instead, one of the cooling systems may be controlled based on information associated with both cooling systems (that is, taking both cooling systems into account).

The temperature of the system may be a coolant inlet temperature of the electronic equipment. This temperature may typically be monitored by cooling systems of electronic equipment and therefore be a useful temperature to use to co-operatively operate the enclosure and electronic cooling systems. The coolant inlet temperature may also indicate the internal temperature of the enclosure.

In cases where there is more than one piece of electronic equipment having a cooling system, step 501 may comprise co-operatively operating a three or more cooling systems based on electrical power information associated with each respective cooling system comprised within a plurality piece of electronic equipment for a temperature of the part of the system, and electrical power information associated with the enclosure cooling system for the temperature.

Similarly, where there is more than one enclosure cooling system, electrical power information associated with the plurality of enclosure cooling systems for the temperature of the part of the system may be used to co-operatively operate the plurality of cooling systems.

Step 501 may comprise applying a target temperature for the part of the system based on the electrical power information associated with the enclosure and electronic equipment cooling systems. This may allow the power consumption of the system to be reduced, limited or minimised. The target temperature may comprise a temperature differential (for example, increasing the coolant inlet temperature by 10°C).

Step 501 may comprise co-operatively operating the first and second cooling systems to reduce or minimise a combined electrical power consumption of the first and second cooling systems.

The method may further comprise, at step 502, sending a signal indicating the temperature of the part of the system. The signal may be transmitted by the electronic equipment where the part of the system is comprised within or is associated with the electronic equipment. The signal may be transmitted by the cooling system of the electronic equipment, which may typically include a sensor for controlling the cooling system. In other examples, the signal may be transmitted by another device - for example, a sensor within the enclosure. It will be appreciated that in some cases, a signal indicating the temperature of the part of the system may be sent prior to step 501.

The signal may be transmitted a plurality of times over a period of time. For example, the signal may be transmitted periodically. The method may return to step 501 after the signal has been transmitted to co-operatively operate the first and second cooling systems based on the temperature information.

A different signal could also or instead be sent at step 502 to report different information. For example, electrical power information may be transmitted. The efficiency of a cooling system may change with time (for example, as parts wear out), so updated power information can be used to co-operatively operate the first and second cooling systems based on more accurate information. The electrical power information may be used to determine a new relationship between the temperature of the part of the system and the electrical power data associated with the cooling system. This may be following a determination that the electrical power information associated with the first and/or second cooling system for the temperature of the part of the system differs from the updated electrical power information.

It will be appreciated that the temperatures and power values discussed herein are exemplary and that other temperatures and power values are possible.

The methods described herein may be implemented with computer system configurations including hand-held devices, microprocessor systems, microprocessor- based or programmable consumer electronics, minicomputers, mainframe computers and the like. The embodiments can also be practiced in distributed computing environments, where tasks are performed by remote processing devices that are linked through a network.

Certain embodiments can also be embodied as computer-readable code on a computer-readable medium. The computer readable medium is any data storage device than can store data, which can thereafter be read by a computer system. Examples of the computer readable medium include hard drives, network attached storage (NAS), read-only memory, random-access memory, CD-ROMs, CD-Rs, CD-RWs, magnetic tapes, and other optical and non-optical data storage devices. The computer readable medium can also be distributed over a network coupled computer systems so that the computer readable code is stored and executed in a distributed fashion. Although embodiments according to the disclosure have been described with reference to particular types of devices and applications (particularly telecommunications and network devices) and the embodiments have particular advantages in such case, as discussed herein, approaches according to the disclosure may be applied to other types of device and/or application. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the aspects and/or features disclosed in this specification may be combined in any combination, except combinations where at least some of such features and/or steps are mutually exclusive. In particular, the preferred features of the disclosure are applicable to all aspects and embodiments of the disclosure and may be used in any combination. Likewise, features described in non-essential combinations may be used separately (not in combination).

It will be appreciated that there is an implied "about" prior to temperatures, electrical powers, voltages, currents, etc. discussed in the present teachings, such that slight and insubstantial deviations are within the scope of the present teachings. Furthermore, values referred to as being "equal" may in fact differ by less than a threshold amount. The threshold amount may be 5%, for example. The threshold may also be greater than 5% (e.g., 10%, 20% or 50%) or less than 5% (for example, 2% or 1 %).

As used herein, including in the claims, unless the context indicates otherwise, singular forms of the terms herein are to be construed as including the plural form and vice versa. For instance, unless the context indicates otherwise, a singular reference herein including in the claims, such as "a" or "an" (such as a server, for instance) means "one or more" (for instance, one or more servers). It will also be appreciated that the terms "one or more" and "at least one" are interchangeable.

Throughout the description and claims of this disclosure, the words "comprise", "including", "having" and "contain" and variations of the words, for example "comprising" and "comprises" or similar, mean "including but not limited to", and are not intended to (and do not) exclude other components. Also, the use of "or" is inclusive, such that the phrase "A or B" is true when "A" is true, "B is true", or both "A" and "B" are true.

The use of any and all examples, or exemplary language ("for instance", "such as", "for example" and like language) provided herein, is intended merely to better illustrate the disclosure and does not indicate a limitation on the scope of the disclosure unless otherwise claimed. No language in the specification should be construed as indicating any non-claimed element as essential to the practice of the disclosure.

The terms "first" and "second" may be reversed without changing the scope of the invention. That is, an element termed a "first" element (e.g. a first cooling system) may instead be termed a "second" element (e.g. a second cooling system) and an element termed a "second" element (e.g. a second cooling system) may instead be considered a "first" element (e.g. a first cooling system). It will also be appreciated that other labelling may be used without changing the scope of the invention (for example, referring to the device by its function or use, such as, for instance, an electronic equipment cooling system or fan management unit).

Any steps described in this specification may be performed in any order or simultaneously unless stated or the context requires otherwise. Moreover, where a step is described as being performed after a step, this does not preclude intervening steps being performed.

It is also to be understood that, for any given component or embodiment described herein, any of the possible candidates or alternatives listed for that component may generally be used individually or in combination with one another, unless implicitly or explicitly understood or stated otherwise. It will be understood that any list of such candidates or alternatives is merely illustrative, not limiting, unless implicitly or explicitly understood or stated otherwise.

In this detailed description of the various embodiments, for the purposes of explanation, numerous specific details are set forth to provide a thorough understanding of the embodiments disclosed. One skilled in the art will appreciate, however, that these various embodiments may be practiced with or without these specific details. Furthermore, one skilled in the art can readily appreciate that the specific sequences in which methods are presented and performed are illustrative and it is contemplated that the sequences can be varied and still remain within the scope of the various embodiments disclosed herein.

All literature and similar materials cited in this application, including but not limited to patents, patent applications, articles, books, treaties and internet web pages are expressly incorporated by reference in their entirety for any purpose. Unless otherwise described, all technical and scientific terms used herein have a meaning as is commonly understood by one of ordinary skill in the art to which the various embodiments described herein belongs.

## Claims

1. A method for controlling a system comprising electronic equipment, the electronic equipment comprising a first cooling system, and an enclosure in which the electronic equipment is installed, the enclosure comprising a second cooling system, the method comprising:
co-operatively operating the first and second cooling systems based on electrical power information associated with the first cooling system for a temperature of part of the system, and electrical power information associated with the second cooling system for the temperature.

2. The method according to claim 1, wherein co-operatively operating the first and second cooling systems comprises applying a target temperature for the part of the system based on the electrical power information associated with the first and second cooling systems for the temperature, wherein optionally the target temperature comprises a temperature differential based on the temperature.

3. The method according to claim any previous claim, further comprising determining a relationship between the temperature and electrical power data associated with the first cooling system and electrical power data associated with the second cooling systems to co-operatively operate the first and second cooling systems, or
wherein co-operatively operating the first and second cooling systems comprises co-operatively operating the first and second cooling systems based on a predetermined relationship between the temperature and electrical power data of the first and second cooling systems, and the electrical power information associated with the first and second cooling systems for the temperature,
wherein optionally the electrical power data comprises the electrical power information associated with the first and second cooling systems for the temperature.

4. The method according to any previous claim, wherein the enclosure comprises a cabinet, wherein optionally the cabinet comprises an outdoor cabinet.

5. The method according to any previous claim, wherein the electronic equipment comprises one or more of: telecommunications equipment, network equipment, transmission equipment, power supply equipment, and power control equipment, one or more servers, one or more rectifiers, one or more routers or modems, and one or more baseband units.

6. The method according to any previous claim, wherein the coolant is air; and/or wherein at least one of the first and second cooling systems comprises a fan.

7. The method according to claim 6 when at least one of the first and second cooling systems comprises a fan, wherein the electrical power information comprises one or more of: a current, a voltage, an electrical power, a fan speed of the fan, and an acoustic fan noise level.

8. The method according to any previous claim, wherein one of more of:
the electrical power information comprises electrical power consumption information, and/or the electrical power information associated with the second cooling system for the temperature comprises electrical power information associated with the second cooling system for a temperature differential between the temperature and an air temperature outside the enclosure.

9. The method according to any previous claim, wherein co-operatively operating the first and second cooling systems comprises co-operatively operating the first and second cooling systems to reduce or minimise a combined electrical power consumption of the first and second cooling systems.

10. The method according to any previous claim, wherein the temperature of the part of the system comprises a coolant inlet temperature of the electronic equipment and/or a temperature within the enclosure.

11. A system comprising:
electronic equipment comprising a first cooling system;
an enclosure in which the electronic equipment is installed, the enclosure comprising a second cooling system; and
a cooling system management unit in communication with the electronic equipment and the second cooling system, wherein the cooling system management unit is configured to co-operatively operate the first cooling system and the second cooling system based on received electrical power information associated with the first cooling system for a temperature of part of the system, and received electrical power information associated with the second cooling system for the temperature.

12. The system according to claim 11, wherein the system is configured in accordance with any of claims 1 to 10.

13. The system according to claim 11 or 12, wherein the cooling system management unit is configured to co-operatively operate the first cooling system and the second cooling system by sending an indication to the electronic equipment to adjust a first cooling system electrical power and sending a separate indication to the second cooling system to adjust a second cooling system electrical power.

14. A computer program comprising instructions that, when executed by a processor, cause the processor to perform the method of any one of claims 1 to 10.

15. A computer-readable medium comprising instructions that, when executed by a processor, cause the processor to perform the method of any one of claims 1 to 10.
